# EUROPEAN PATENT APPLICATION

(11) **EP 4 478 366 A2**
(43) Date of publication of application: **18.12.2024**
(21) Application number: 24182314.5
(22) Date of filing: 14.06.2024
(51) Int. Cl.: G11C 29/32, G11C 29/42, G11C 29/00, G11C 29/36, G11C 11/16, G11C 29/12

(54) **DISTRIBUTED MRAM CONFIGURATION BIT AND METHOD OF REPAIR**

(30) Priority: 15.06.2023 US 202363508305 P; 11.06.2024 US 202418739969
(71) Applicant: Everspin Technologies, Inc., Chandler, AZ 85226 (US)
(72) Inventor: ALAM, Syed M., CHANDLER, 85226 (US); WILLIAMS, Jacob T., CHANDLER, 85226 (US); SADD, Michael A., CHANDLER, 85226 (US); NAGEL, Kerry Joseph, CHANDLER, 85226 (US); IKEGAWA, Sumio, CHANDLER, 85226 (US); MANCOFF, Frederick B., CHANDLER, 85226 (US); AGGARWAL, Sanjeev, CHANDLER, 85226 (US)
(74) Representative: Eisenführ Speiser

(57) **Abstract**

A memory device including a first configuration bit group including a plurality of bits, the plurality of bits including: a plurality of configuration bits; at least one redundant configuration bit; a plurality of configuration bit multiplexers each configured to receive (i) a first input from a first bit in the plurality of bits and/or a second input from a second bit in the plurality of bits and (ii) a third input from a decoder, each of the first, second, and third inputs indicating a respective logical state, wherein the logical state includes a first state or a second state; and wherein, based on the logical state of the third input received from the decoder, each configuration bit multiplexer is configured to output: the logical state of the first input from the first bit, or the logical state of the second input from the second bit.

## Description

### CROSS-REFERENCE TO RELATED APPLICATION

This application claims benefit of priority to U.S. Provisional Patent Application No. 63/508,305, filed June 15, 2023, the entire contents of which are incorporated herein by reference.

### TECHNICAL FIELD

Embodiments of the present disclosure relate to, among other things, configuration bits in non-volatile distributed memory. More specifically, certain embodiments of the present disclosure relate to using redundant bits in configuration bit clusters in non-volatile distributed memory as a repair mechanism.

### INTRODUCTION

In general, a memory device may include arrays of bits to store information. However, bits may have defects from manufacturing or be damaged thereafter, lowering performance of, or even rendering inoperative, the memory devices. Defective bits may include bits that are stuck in one logical state or another. Therefore, it is desirable to have a memory device that includes mechanisms to compensate for defective or damaged bits.

### BRIEF DESCRIPTION OF THE DRAWINGS

In the course of the detailed description that follows, reference will be made to the appended drawings. The drawings show different aspects of the present disclosure and, where appropriate, reference numerals illustrating like structures, components, materials, and/or elements in different figures are labeled similarly. It is understood that various combinations of the structures, components, and/or elements, other than those specifically shown, are contemplated and are within the scope of the present disclosure.

Moreover, there are many embodiments of the present disclosure described and illustrated herein. The present disclosure is neither limited to any single aspect nor embodiment thereof, nor to any combinations and/or permutations of such aspects and/or embodiments. Moreover, each of the aspects of the present disclosure, and/or embodiments thereof, may be employed alone or in combination with one or more of the other aspects of the present disclosure and/or embodiments thereof. For the sake of brevity, certain permutations and combinations are not discussed and/or illustrated separately herein; however, all permutations and combinations are considered to fall within the scope of the present inventions.
FIG. 1 depicts a diagram of a configuration bit, according to aspects of this disclosure.
FIG. 2 depicts a diagram of a group of configuration bits, according to aspects of this disclosure.
FIG. 3 depicts a diagram of a group of configuration bits including a redundant bit, according to aspects of this disclosure.
FIG. 4 depicts a diagram of two groups of configuration bits including respective redundant bits, according to aspects of this disclosure.
FIG. 5 depicts a diagram of a decoder, according to aspects of this disclosure.
FIG. 6 depicts a diagram illustrating inversion with tag memory, according to aspects of this disclosure.
FIG. 7 depicts a diagram illustrating inversion with triple modular redundancy, according to aspects of this disclosure.
FIG. 8 depicts a circuit diagram of a configuration bit including redundant magnetic tunnel junction networks, according to aspects of this disclosure.
FIG. 9 depicts a cross-sectional view of vertically-stacked magnetic tunnel junction layers, according to aspects of this disclosure.
FIG. 10 depicts a top view of a configuration bit including redundant bits, according to aspects of this disclosure.

Again, there are many embodiments described and illustrated herein. The present disclosure is neither limited to any single aspect nor embodiment thereof, nor to any combinations and/or permutations of such aspects and/or embodiments. Each of the aspects of the present disclosure, and/or embodiments thereof, may be employed alone or in combination with one or more of the other aspects of the present disclosure and/or embodiments thereof. For the sake of brevity, many of those combinations and permutations are not discussed separately herein.

As used herein, the terms "comprises," "comprising," "has," "having," "includes," "including," or any other variation thereof, are intended to cover a non-exclusive inclusion, such that a process, method, article, or apparatus that comprises a list of elements does not include only those elements, but may include other elements not expressly listed or inherent to such process, method, article, or apparatus. The term "exemplary" is used in the sense of "example," rather than "ideal.

### DETAILED DESCRIPTION

Detailed illustrative aspects are disclosed herein. However, specific structural and functional details disclosed herein are merely representative for purposes of describing example embodiments of the present disclosure. The present disclosure may be embodied in many alternate forms and should not be construed as limited to only the embodiments set forth herein. Further, the terminology used herein is for the purpose of describing particular embodiments only and is not intended to be limiting of exemplary embodiments described herein.

When the specification makes reference to "one embodiment" or to "an embodiment," it is intended to mean that a particular feature, structure, characteristic, or function described in connection with the embodiment being discussed is included in at least one contemplated embodiment of the present disclosure. Thus, the appearance of the phrases, "in one embodiment" or "in an embodiment," in different places in the specification does not constitute a plurality of references to a single embodiment of the present disclosure.

As used herein, the singular forms "a," "an," and "the" are intended to include the plural forms as well, unless the context clearly indicates otherwise. It also should be noted that in some alternative implementations, the features and/or steps described may occur out of the order depicted in the figures or discussed herein. For example, two steps or figures shown in succession may instead be executed substantially concurrently or may sometimes be executed in the reverse order, depending upon the functionality/acts involved. In some aspects, one or more described features or steps may be omitted altogether, or may be performed with an intermediate step therebetween, without departing from the scope of the embodiments described herein, depending upon the functionality/acts involved.

Further, the terms "first," "second," and the like, herein do not denote any order, quantity, or importance, but rather are used to distinguish one element from another. Similarly, terms of relative orientation, such as "top," "bottom," etc. are used with reference to the orientation of the structure illustrated in the figures being described. It should also be noted that all numeric values disclosed herein may have a variation of ±10% (unless a different variation is specified) from the disclosed numeric value. Further, all relative terms such as "about," "substantially," "approximately," etc. are used to indicate a possible variation of ±10% (unless noted otherwise or another variation is specified).

In some aspects, this disclosure is directed to devices and implementations of storage and/or processing devices, including, e.g., non-volatile or "permanent" memory (e.g., Flash, MRAMs, or ReRAMs). The devices and implementations include storage and/or processing devices with integrated controllers or control circuity, for example, for field programmable gate array (FPGA) system(s). The devices and implementations may help to reduce necessary space, reduce necessary connections, reduce errors, improve processing speed, and/or otherwise improve performance. Though the description below makes reference to MRAM devices, the disclosed embodiments may be implemented in other memory devices including, but not limited to, electrically erasable programmable read-only memory (EEPROM), resistive random-access-memory (ReRAM), NOR/NAND Flash, and/or ferroelectric random-access memory (FRAM).

The embodiments described herein present different repair mechanisms for a memory device, including memory devices including configuration bits, by employing redundancy structures to fix manufacturing defects (also known as time=0 stuck defects) and/or damage that leave individual magnetic tunnel junction (MTJ) devices or configuration bits thereof stuck at a given logical state. The embodiments described herein may also improve the bit error rate (BER) of configuration bits that may be storing one-time or multiple-time programmable data, such as time-0 stuck information, or any other types of data.

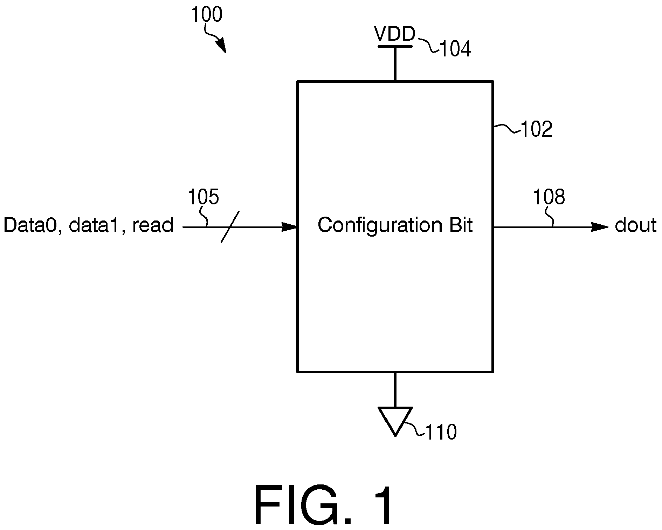

FIG. 1 depicts a diagram of a memory device 100 including a configuration bit (or simply "config bit") 102 in, e.g., a non-volatile memory (NVM). Configuration bit 102 may store data in the form of logical states, e.g., 1 or 0, for future access. "Access," as used herein, may mean either write or read operations performed on config bit 102 by write or read circuitry (not shown in FIG. 1). Each config bit 102 may include one or more magnetic tunnel junctions (MTJs) (not individually shown) used to store that data in the form of, e.g., a logical 1 or logical 0. For example, config bit 102 may be a single-bit NVM implemented with multiple MTJs to store data for, e.g., a computing device. Config bit 102 may generally be compatible with a standard cell compatible layout, and require no bias system or high-voltage circuitry for operation.

Config bit 102 may include a power source 104, an input 105, an output 108, and a ground connection 110. Power source 104, also denoted VDD in FIG. 1, may be used to power config bit 102 for read and write operations. Data may be input as, e.g., three inputs: data0, data1, or read. Data0 and data1 refer to writing (also known as "programming") config bit 102 to a logical state of a 0 or a 1, respectively, while read refers to a read operation, e.g., reading the logical state of config bit 102 at output 108, denoted "dout" in FIG. 1. Input 105 and output 108 may include digital inputs and outputs, respectively. Config bit 102 may be read with a power ramp in less than, e.g., 5 nanoseconds read time. Config bit 102 may be electrically connected to ground 110, thereby completing an electrical circuit. Each config bit 102 may be any appropriate memory type, including one of a toggle magnetoresistive random access memory (MRAM), a spin orbit torque (SOT) MRAM, a spin transfer torque (STT) MRAM, or a voltage-controlled magnetic anisotropy (VCMA) MRAM.

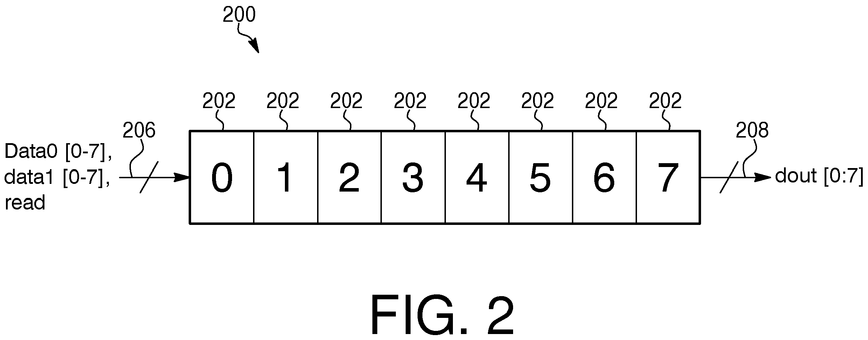

FIG. 2 depicts a diagram of a group 200 of configuration bits 202. That is, multiple config bits 202 can be grouped or electrically coupled together to create a cluster or chain 200 (e.g., scan chain) of config bits 202 of desired density. As used herein, a "group" of config bits refers to grouped/clustered config bits 202 and/or chained (e.g., electrically coupled, such as in, e.g., a scan chain) config bits 202. Input 206 may represent a single input to group 200 of config bits 202 where each config bit 202 is electrically coupled to one another. Alternatively, group 200 of config bits 202 may include an input 206 and output 208. Input 206 may represent a single or multiple inputs to each config bit 202 in the group 200 of config bits 202, including multiple inputs for different operations, similar or even identical to config bit 102 in other implementations. For example, data0 [0-7] and data1 [0-7] at input 206 represent the write operations for logical 0 and logical 1 for each config bits 202 in the group 200 of config bits 202. A read operation may be input into each config bit 202 in the group 200 of config bits 202, which initiates a read sequence and outputting of dout at output 208. Dout [0-7] represents the output of each config bit 202 in the group 200 of config bits 202.

An NVM may include as many groups 200 of config bits 202 as appropriate. Moreover, each group 200 of config bits 202 may include any appropriate number of config bits 202. For example, in an embodiment shown in FIG. 2, the group 200 of config bits 202 may include 8 config bits. However, exemplary embodiments are not limited to 8 config bits. A non-exhaustive list of the number of config bits 202 in a group 200 of config bits 202 may include: 8 config bits, 16 config bits, 32 config bits, 64 config bits, 128 config bits, and 256 config bits. In other implementations, NVM devices may include any number of groups 200 of config bits 202, including between 1 kilobyte to many petabytes or more.

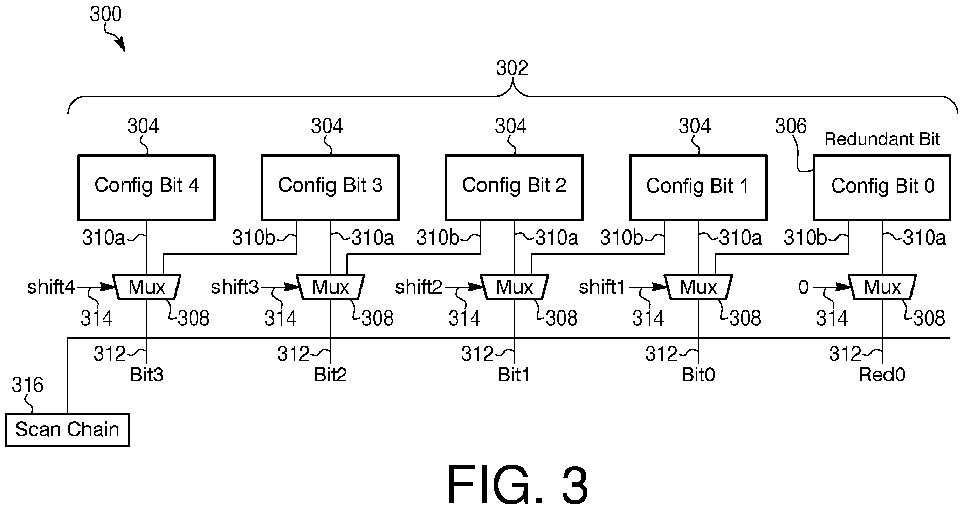

FIG. 3 depicts a diagram of a memory device 300 including a config bit group 302 including a plurality of bits (labeled Config Bits 0-4). As discussed above, a "group" of config bits refers to grouped/clustered config bits and/or chained (e.g., electrically coupled, such as in, e.g., a scan chain) config bits. The plurality of bits in the group 302 may include configuration bits 304 and at least one redundant configuration bit 306 (also referred to herein as redundant bit 306). As discussed herein, redundant bit 306 may be used to repair memory device 300 in the event that one of the config bits 304 is defective. Each config bit 304 in the plurality of bits 302 may be substantially similar or the same as config bits described in other implementations herein. Redundant bit 306 may also be in the form of a config bit, except that the output of redundant bit 306 is read only when a defect is present in the config bits 304 in the plurality of bits 302. One or more redundant bits 306 are added in a group of n config bits, where n is equal to any positive integer (n=4 in FIG. 3, for example).

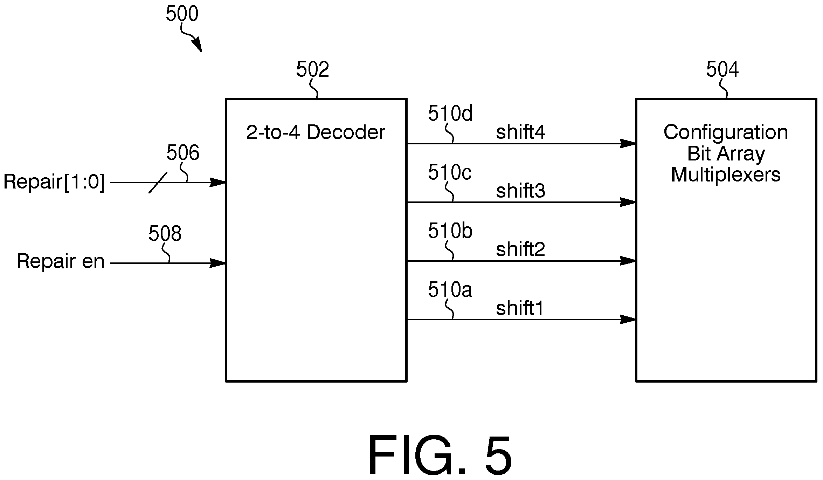

Memory device 300 may include a plurality of configuration bit multiplexer circuits 308 (or simply "multiplexers"), each configured to receive a first input 310a from a first bit in the plurality of bits 304, and/or a second input 310b from a second bit in the plurality of bits 304. Each multiplexer circuit 308 may include a third input 314 (also referred to herein as a shift input or shift signal, denoted in FIG. 3 as shift1-4 for each config bit 304 and 0 for redundant bit 306) programmed via a decoder (e.g., FIG. 5). Each multiplexer circuit 308 may include an output 312 (labeled Bit0-3 for each config bit 304 and RedO for redundant bit 306) where the data stored in memory device 300 is read.

Memory device 300 may include a scan chain 316 electrically connected to the plurality of bits 302 through respective outputs 312 of the multiplexers 308. A scan chain is a series of flip-flop circuits (or latches) connected in a sequence, thereby creating a shift register for testing the outputs of bits 302. A scan chain may also be used for providing inputs to the bits 302. Prior to any repair (e.g., correction of defective bits 304), all the bits (bit0-bit3 and redO) are tested for any stuck-at fault (e.g., permanently stuck at one logical state or another) via scan chain 316. Accordingly, scan chain 316 may be configured to test output 312 of each bit in the plurality of bits 304 to determine if any bit is faulty/defective. This testing can be performed using a scan chain 316 or by directly reading the outputs Bit0-3 and RedO with each third input 314 held at the first logical state. While not shown for simplicity, alternate embodiments of the scan chain 316 may exist where the scan chain 316 is comprised of a series of flip-flop circuits (or latches) and config bit 302 connected in a sequence or just config bits 302 connected in a sequence.

Each of first, second, and third inputs 310a, 310b, and 314, respectively, may indicate a respective logical state. The logical state may include a first state or a second state. Based on the logical state of the third input 314 received from the decoder, each configuration bit multiplexer circuit 308 is configured to output the logical state of the first input 310a from the first bit, or the logical state of the second input 310b from the second bit.

For example, if shift input 314 has a first logical state, the corresponding multiplexer 308 outputs a first input 310a received from the corresponding config bit (e.g., in FIG. 3, the config bit that directly lies above the multiplexer 308 in question). On the other hand, if shift input 314 has a second logical state, the corresponding multiplexer 308 outputs a second input 310b received from a neighboring config bit (e.g., in FIG. 3, the config bit that is shown to be situated at the immediate upper right side of the multiplexer 308 in question). The shift input 314 may be set to the second logical state when the corresponding config bit (e.g., in FIG. 3, the config bit that lies directly above the multiplexer 308 to which the shift input 314 is provided) has been determined to be stuck. Further, the shift inputs to the multiplexers 308 that correspond to (e.g., in FIG. 3, lies directly below) the redundant bit 306 and any config bit(s) that is between the stuck config bit and the redundant bit may also be set to the second logical state. As an example, if Config bit 2 is stuck in FIG. 3, shift inputs may be set as follows: shift2=1 allows Bit1=Config bit 1, shift1=1 allows bit0=Config bit 0 while shift3 and shift4 remains 0. Thus, a faulty bit1 is repaired in this example. Shift signals can be encoded to store in one time programmable memory (also known as "OTP memory") during repair. Repairing a defective config bit 304 may be applied where plurality of bits 302 includes any number of bits.

Each bit in the plurality of bits 304 may be part of any greater NVM structure, including one of a toggle magnetoresistive random access memory (MRAM), a spin orbit torque (SOT) MRAM, a spin transfer torque (STT) MRAM, or a voltage-controlled magnetic anisotropy (VCMA) MRAM.

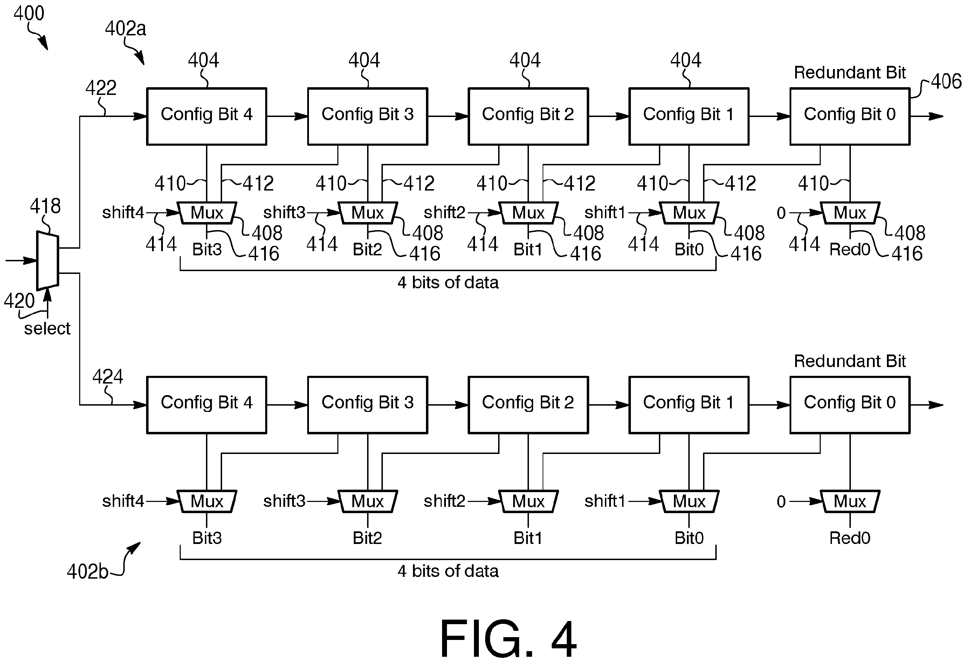

FIG. 4 depicts a memory device 400 including first configuration bit group 402a and a second configuration bit group 402b. First and second configuration bit groups 402a and 402b may be substantially similar or even identical to other configuration bit groups described herein or to one another. That is, first and second configuration bit groups 402a and 402b may each include a plurality of config bits 404 and a redundant bit 406. Memory device 400 may include a multiplexer 408 connected to each bit in the group 402a, 402b, including both the config bits 404 and redundant bit 406. Multiplexer circuits 408 are the same as multiplexers in other implementations, e.g., they include a first input 410, a second input 412, and a third input 414 and an output 416. Components in the second configuration bit group 402b are not separately labeled in FIG. 4 for brevity, as they are substantially identical to those of the first configuration bit group 402a, which should be apparent to a person of ordinary skill in the art. Memory device 400 may further include a configuration bit group multiplexer 418 including: a select input 420, a first output 422 to an input of the first configuration bit group 402a, and a second output 424 to an input of the second configuration bit group 402b. Based on a logical state of select input 420 to configuration bit group multiplexer 418, configuration bit group multiplexer 418 is configured to selectively access one of first configuration bit group 402b or second configuration bit group 402b. In this way, if either first configuration bit group 402a or second configuration bit group 402b is non-functional, memory device 400 may selectively use first configuration bit group 402a or second configuration bit group 402b for memory storage.

In some embodiments, one of the two group may be used for endurance screen test after manufacturing, where the scan chain of config bits are cycled through read and/or write operations to stress the config bits, which may cause breakdown during the test. The cycling tests enable endurance screening test. During normal operation, the cycled chain may not be used as it was already stressed and may have faulty bits or be more prone to defects.

FIG. 5 depicts a diagram of memory device 500 including a decoder 502, which may be configured to selectively program the third input (e.g., shift input or shift signal) provided to each configuration bit multiplexer 504 (e.g., the multiplexers for the configuration bits 304, 404 depicted in FIGs. 3-4) based on whether and/or where a faulty configuration bit exists. Decoder 502 may include various inputs, including a first input 506 (labeled Repair [1:0]) and a second input 508 (labeled Repair en). Decoder 502 may include outputs 510a-d (labeled individually as shifts1-4). In one embodiment, decoder 502 may be, e.g., a 2-to-4 decoder.

Upon manufacturing, at time=0, a user may test memory devices 300 and/or 400 for defects in the plurality of bits. If a defect is detected, the user may utilize a decoder to program the third input of the multiplexers selectively to make the redundant bit operational. Decoder 502 may include, e.g., a binary encoder. Decoder 502 may reduce the number of bits needed to store repair information.

Table 1 below describes the input values (denoted Repair[1:0] and Repair_en) and corresponding output values of decoder 502 that are input to shift1-4 of the multiplexers for the config bits.

**Table 1**

| | |
|---|---|
| Repair[1:0]=00, Repair_en=0 | shift4=0, shift3=0, shift2=0, shift 1=0 |
| Repair[1:0]=00, Repair_en=1 | shift4=0, shift3=0, shift2=0, shift 1=1 |
| Repair[1:0]=01, Repair_en=1 | shift4=0, shift3=0, shift2=1, shift 1=1 |
| Repair[1:0]=10, Repair_en=1 | shift4=0, shift3=1, shift2=1, shift 1=1 |
| Repair[1:0]=11, Repair_en=1 | shift4=1, shift3=1, shift2=1, shift 1=1 |

In Table 1, the first logical state is denoted 0, while the second logical state is denoted 1. When input Repair[1:0]=00 and Repair_en=0, then shifts1-4=0 (this represents a condition where all config bits are working property, e.g., not defective or stuck). When input Repair[1:0]=00 and Repair_en=1, then shift1=1 and shifts2-4=0. When input Repair[1:0]=01 and Repair_en=1, then shifts1-2=1 and shifts3-4=0. When input Repair[1:0]=10 and Repair_en=1, then shifts1-3=1 and shift4=0. When input Repair[1:0]=11 and Repair_en=1, then shifts1-4=1.

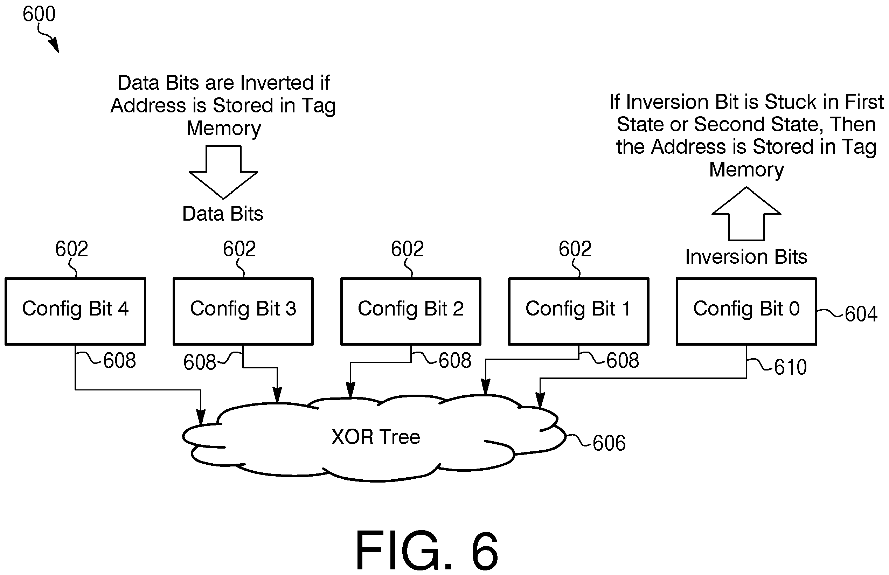

FIG. 6 depicts a diagram of a memory device 600 including a plurality of configuration bits 602 and a configuration inversion bit 604 (also to referred to herein as an inversion bit 604). Each of the plurality of configuration bits 602 and inversion bit 604 may have a respective logical state including a first state or a second state. Memory device 600 may include an exclusive OR (XOR) tree circuit 606 configured to receive an output 608 from each of the plurality of configuration bits 602. Inversion bit 604 may take the form of, e.g., a config bit (labeled Config Bit 0 for clarity) and provide output 610 to the XOR tree circuit 606.

In one embodiment, the plurality of configuration bits 602 may include, e.g., at least four configuration bits 602 (labeled Config Bits 1-4). However, the plurality of configuration bits 602 may include more or less than 4 configuration bits 602. Each of the plurality of configuration bits 602 and the inversion bit 604 may be one of a toggle magnetoresistive random access memory (MRAM), a spin orbit torque (SOT) MRAM, a spin transfer torque (STT) MRAM, or a voltage-controlled magnetic anisotropy (VCMA) MRAM. Each of the plurality of configuration bits 602 and the inversion bit 604 may include inputs (not shown) electrically coupled to other devices (e.g., logic, a central processing unit, a graphics processing unit) through buses, and outputs 608 and 610 to the XOR tree circuit 606.

When inversion bit 604 is defective (e.g., permanently stuck in the first state or the second state), the output 608 of each configuration bit 602 in plurality of configuration bits 602 may be stored in a first portion of NVM having an address. Each output 608 is configured to be output by the XOR tree circuit 606, and the address is selectively stored in a second portion of NVM when the inversion bit 604 is stuck at the first state or the second state. The logical state of each configuration bit 602 is inverted when the address is stored in the second portion of NVM, referred to as "tag memory." That is, if the inversion bit 604 is stuck in the first state or the second state, then the address of the data bits is stored in a tag memory portion of NVM. The data bits output by the XOR tree circuit 606 of the configuration bits 602 are inverted if the address of the data bits is stored in a tag memory portion of NVM.

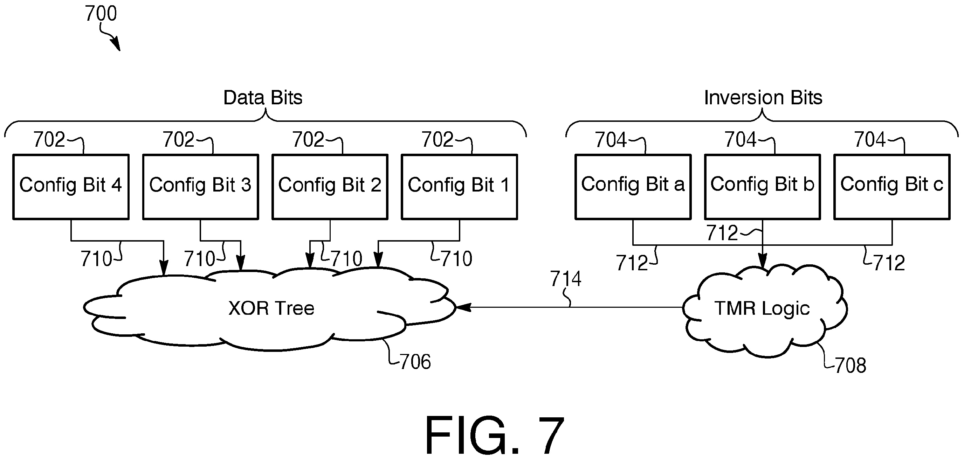

FIG. 7 depicts a circuit diagram of a memory device 700. Memory device 700 may be similar to memory device 600, including a plurality of config bits 702 (individually labeled Config Bits 1-4 for clarity) and an exclusive OR (XOR) tree circuit 706, except that inversion bit 604 of memory device 600 may include a plurality of inversion bits 704 including, e.g., three config bits (individually labeled Config Bits a, b, and c for clarity) and a triple modular redundancy (TMR) circuit 708 (e.g., a TMR logic circuit) instead of a tag memory mechanism.

The config bits 702 may be similar to the config bits described in other implementations herein, and may include inputs (not shown) and outputs 710 to XOR tree circuit 706. Similarly, the inversion bits 704 may be similar to config bits in other implementations described herein, except that there may be, e.g., at least three inversion bits 704. Each inversion bit 704 may include inputs (not shown) and outputs 712 to the TMR logic circuit 708. The outputs 712 indicating the logical states of the inversion bits 704 may be provided into (e.g., may be input to) the TMR logic circuit 708, which may be configured to determine the logical state of the inversion bits 704 by performing a majority voting based on the logical states of the plurality of inversion bits 704 and output the determined logical state of the inversion bit 704 to the XOR tree circuit 706. Majority voting, as used herein, may mean that at least two of the three inversion bits 704 have the same state. The TMR logic circuit 708 may provide the result of the majority voting, which represents the logical state of the inversion bits 704, as an input to the XOR tree circuit 706. If the majority voting at the TMR logic circuit 708 results in a first state to be representative of the inversion bits 704, the TMR logic circuit 708 may provide an output 714 indicating the first state to the XOR tree circuit 706. When the first state is provided to the XOR tree circuit 706, the XOR tree circuit 706 may output the logical state of each corresponding configuration bit 702. If the majority voting at the TMR logic 708 results in a second state to be representative of the inversion bits 704, the TMR logic circuit 708 may provide an output 714 indicating the second state to the XOR tree circuit 706. When the second state is provided to the XOR tree circuit 706, the XOR tree circuit 706 may invert the logical state of each corresponding configuration bit in the plurality of configuration bits 702 and output the inverted logical states of the configuration bits 702.

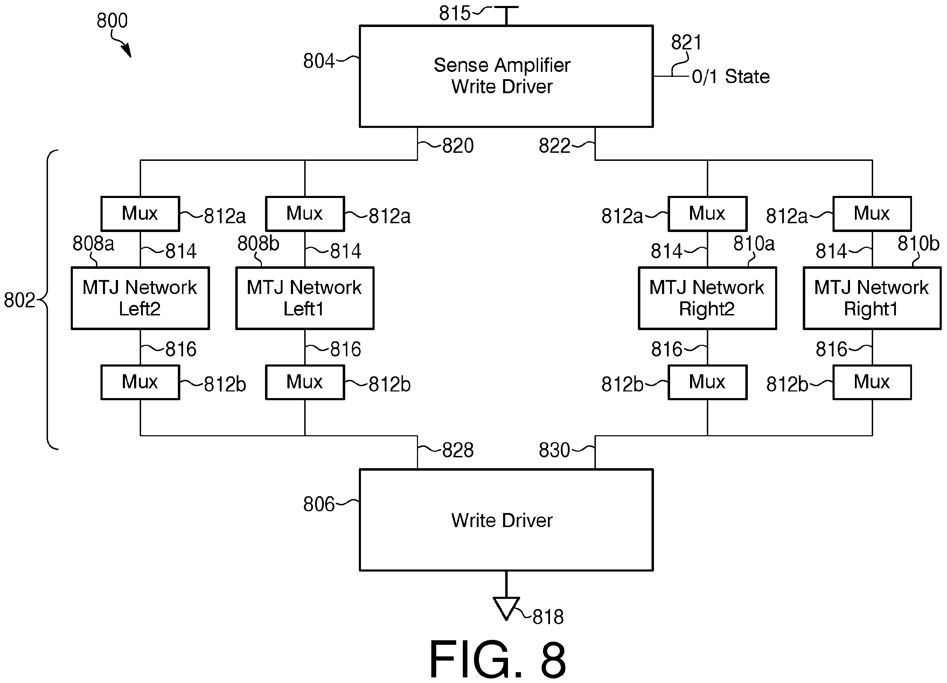

FIG. 8 depicts a circuit diagram of a memory device 800. Memory device 800 may include or take the form of a configuration bit, which may be one of a toggle magnetoresistive random access memory (MRAM), a spin orbit torque (SOT) MRAM, a spin transfer torque (STT) MRAM, or a voltage-controlled magnetic anisotropy (VCMA) MRAM.

The memory device 800 may include a magnetic tunnel junction (MTJ) array 802 electrically connected to a sense amplifier write driver circuit 804 and a write driver circuit 806. MTJ array 802 may include a first plurality of MTJ networks including MTJ network 808a and MTJ network 808b electrically coupled in parallel with one another, and a second plurality of MTJ networks including MTJ network 810a and MTJ network 810b electrically coupled in parallel with one another. The first plurality of MTJ networks 808a-b may be substantially similar or even identical to the second plurality of MTJ networks 810a-b. The first plurality of MTJ networks 808a, 808b and the second plurality of MTJ networks 810a, 810b may each include the same number of MTJ networks, e.g., 2, 4, 8, 16, 32, 64, 128, 256 MTJs, etc. Each MTJ network 808a, 808b, 810a, 810b may be electrically connected to the sense amplifier write driver circuit 804 and the write driver circuit 806 via respective multiplexers 812a and 812b.

The sense amplifier write driver circuit 804 and write driver circuit 806 may be configured to access data stored in the MTJ array 802. The sense amplifier write driver 804 may include a power source input 815 and a first output 821 which outputs the current logical state of the MTJ array 802, and second output 820 and third output 822 to the multiplexers 812a of MTJ networks 808a and 808b, and 810a and 810b, respectively. Outputs 820 and 822 may test a resistance of MTJ networks 808a or 808b and 810a or 810b, thereby determining the logical state of MTJ array 802. The write driver 806 may include inputs 828 and 830 from respective MTJ networks 808a, 808b and 810a, 810b. The write driver 806 may be electrically coupled to ground 818.

The multiplexers 812a may include inputs connected to the outputs 820 and 822 of the sense amplifier write driver 804, and may include outputs 814 that electrically couple multiplexers 812a to respective MTJ networks 808a, 808b, 810a, and 810b. The multiplexers 812b may include inputs 816 from respective MTJ networks 808a, 808b, 810a, and 810b. Respective outputs of the multiplexers 812b electrically couple multiplexers 812b to inputs 828 and 830 of the write driver 806.

The plurality of multiplexers 812a-b may be configured to select an MTJ network in the first plurality of networks 808a, 808b and/or the second plurality of networks 810a, 810b if one or more MTJs in one or more other MTJ networks 808a, 808b, 810a, or 810b are faulty. For example, if one of MTJ networks 808a or 808b was faulty, the faulty network may be switched off by a user by switching an input into the multiplexers 812a and/or 812b from a first state to a second state. Similarly, if one of MTJ networks 810a or 810b was faulty, the faulty network may be switched off by a user by switching an input into the multiplexers 812a and/or 812b from a first state to a second state. While multiplexers 812a and 812b are illustrated as individual multiplexers, multiplexers 812a connecting the sense amplifier write driver 804 to the MTJ networks 808a and 808b may be a single multiplexer circuit, and multiplexers 812b connecting the MTJ networks 808a and 808b to the write driver 806 may be a single multiplexer circuit. Similarly, the multiplexers 812a connecting the sense amplifier write driver 804 to the MTJ networks 810a and 810b may be a single multiplexer circuit, and the multiplexers 812b connecting the MTJ networks 810a and 810b to the write driver 806 may be a single multiplexer circuit.

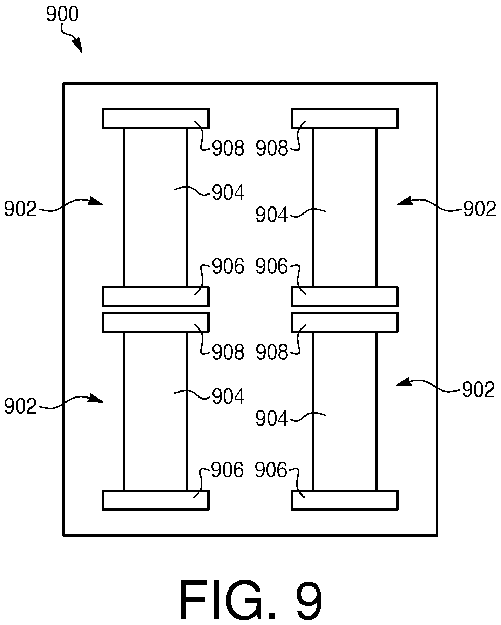

FIG. 9 depicts a cross-sectional view of a memory device 900 including a plurality of MTJ stacks 902 in MTJ networks described herein. As shown in FIG. 9, the MTJ stacks 902 may be placed vertically adjacent each other and/or horizontally adjacent each other. The vertically-stacked MTJ stacks may be adjacent to or spaced apart from one another. Each MTJ stack 902 may include: a bottom electrode 906, a top electrode 908, and an MTJ 904 including a free layer, a fixed layer, and a tunnel barrier layer between the free layer and the fixed layer. The free layer may be above the tunnel barrier layer or below the tunnel barrier layer, and the fixed layer may be on the other side of the tunnel barrier layer relative to the free layer. The vertically and/or horizontally-placed MTJ stacks 902 illustrated in FIG. 9 may be used in any embodiment described herein. By placing the MTJ stacks 902 vertically and/or horizontally adjacent to each other, device density is increased and layout area may be saved. For example, with the additional layout area, more redundant bits may be included in memory devices described herein.

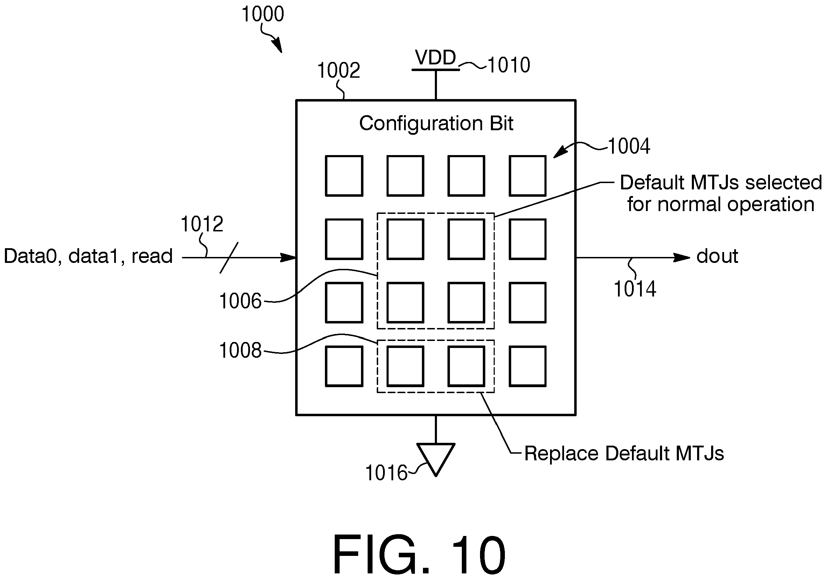

FIG. 10 depicts a top-down view of a memory device 1000. Memory device 1000 may take the form of a config bit 1002. The memory device 1000 may include a plurality of bits 1004 (which may utilize MTJs), including default bits 1006 (also referred to herein as default MTJs 1006), which are configured to be used during normal operation, and redundant bits 1008, which may replace the default bits 1006 if one or more of the default bits 1006 are defective (e.g., stuck). The memory device 1000 may include a power source 1010, an input 1012, an output 1014, and a ground connection 1016. Power source 1010, also denoted VDD in FIG. 10, may be used to power the memory device 1000. Data may be input at input 1012 as, e.g., three inputs: data0, data1, or read. Data0 and data1 refer to writing (also known as "programming") default bits 1006 and/or redundant bits 1008 to a logical state of a 0 or a 1, respectively, while "read" refers to a read operation, e.g., reading the logical state of the memory device 1000 at output 1014, denoted "dout." Input 1012 and output 1014 may include digital inputs and outputs, respectively. The embodiment illustrated in FIG. 10, depicting how the default bits and redundant bits may be arranged within a configuration bit to implement a repair mechanism, may be applicable to and utilized in any of the other embodiments illustrated in the present disclosure.

The foregoing description of the inventions has been described for purposes of clarity and understanding. It is not intended to limit the inventions to the precise form disclosed. Various modifications may be possible within the scope and equivalence of the application.

In one embodiment, a memory device may comprise a first configuration bit group including a plurality of bits, the plurality of bits including: a plurality of configuration bits; at least one redundant configuration bit; a plurality of configuration bit multiplexers each configured to receive (i) a first input from a first bit in the plurality of bits and/or a second input from a second bit in the plurality of bits and (ii) a third input from a decoder, each of the first, second, and third inputs indicating a respective logical state, wherein the logical state includes a first state or a second state; and wherein, based on the logical state of the third input received from the decoder, each configuration bit multiplexer is configured to output: the logical state of the first input from the first bit, or the logical state of the second input from the second bit.

Various embodiments may comprise, without limitation: wherein, when one of the plurality of configuration bits is faulty, at least one of the plurality of configuration bit multiplexers receives the second input from the second bit in the plurality of bits; wherein, when one of the plurality of configuration bits is faulty, at least one of the plurality of configuration bit multiplexers receives the second input from the second bit in the plurality of bits, the second bit being the at least one redundant configuration bit; wherein the decoder is configured to selectively program the third input provided to each configuration bit multiplexer based on whether and/or where a faulty configuration bit exists; further comprising at least one redundant configuration bit multiplexer configured to receive an input from the at least one redundant configuration bit; further comprising a scan chain electrically connected to the plurality of bits and configured to test an output of each bit in the plurality of bits to determine any faulty bit; wherein the each bit in the plurality of bits is one of a toggle magnetoresistive random access memory (MRAM), a spin orbit torque (SOT) MRAM, a spin transfer torque (STT) MRAM, or a voltage-controlled magnetic anisotropy (VCMA) MRAM; and further comprising: a second configuration bit group substantially identical to the first configuration bit group; and a configuration bit group multiplexer including: a select input, a first output to an input of the first configuration bit group, and a second output to an input of the second configuration bit group, wherein, based on a logical state of the select input to the configuration bit group multiplexer, the configuration bit group multiplexer is configured to selectively access one of the first configuration bit group or the second configuration bit group.

In another embodiment, a memory device may comprise: a plurality of configuration bits; an inversion bit, each of the plurality of configuration bits and the inversion bit having a respective logical state, wherein the logical state includes a first state or a second state; and an exclusive OR (XOR) tree circuit configured to receive an input from each of the plurality of configuration bits and the inversion bit and: if the inversion bit includes the first state, output the logical state of each corresponding configuration bit in the plurality of configuration bits, or if the inversion bit includes the second state, invert the logical state of each corresponding configuration bit in the plurality of configuration bits.

Various embodiments may comprise, without limitation: wherein the inversion bit includes a plurality of inversion bits, and wherein the memory device further comprises: a triple modular redundancy (TMR) circuit configured to determine the logical state of the inversion bit by performing a majority voting based on the logical states of the plurality of inversion bits and output the determined logical state of the inversion bit to the XOR tree circuit; wherein the output of each configuration bit in the plurality of configuration bits is stored in a first portion of non-volatile memory having an address and is configured to be output by the XOR tree circuit, wherein the address is selectively stored in a second portion of the non-volatile memory when the inversion bit is fixed at the first state or the second state, and wherein the logical state of each configuration bit in the plurality of configuration bits is inverted when the address is stored in the second portion of non-volatile memory; wherein the each configuration bit in the plurality of configuration bits is one of a toggle magnetoresistive random access memory (MRAM), a spin orbit torque (SOT) MRAM, a spin transfer torque (STT) MRAM, or a voltage-controlled magnetic anisotropy (VCMA) MRAM; and wherein the plurality of configuration bits includes at least four configuration bits.

In yet another embodiment, a memory device may comprise a magnetic tunnel junction (MTJ) array electrically connected to a sense amplifier write driver circuit and to a write driver circuit, the MTJ array including: a first plurality of MTJ networks electrically coupled in parallel with one another, and a second plurality of MTJ networks electrically coupled in parallel with one another, wherein each MTJ network of the first plurality and the second plurality of MTJ networks includes a plurality of MTJs and is connected to the sense amplifier write driver circuit and the write driver circuit via respective multiplexers of a plurality of multiplexers, wherein the plurality of multiplexers are configured to select an MTJ network in the first plurality of networks and/or the second plurality of networks if one or more MTJs in one or more other MTJ networks in the first plurality of networks and/or the second plurality of networks are faulty.

Various embodiments of the memory device may comprise, without limitation: wherein the plurality of MTJs in each MTJ network are placed vertically adjacent each other and/or horizontally adjacent each other; wherein the memory device is a configuration bit; wherein each MTJ in the plurality of MTJs includes an MTJ stack including: a bottom electrode, a top electrode, a free layer between the bottom electrode and the top electrode, a fixed layer between the bottom electrode and the top electrode, a barrier layer between the free layer and the fixed layer; wherein the first plurality of MTJ networks and the second plurality of MTJ networks each include the same number of MTJ networks; wherein each MTJ network in the first plurality of MTJ networks and in the second network of MTJs includes a first multiplexer electrically connected to an input of the respective MTJ network and a second multiplexer electrically connected to a respective output of the respective MTJ network; and wherein the memory device is a configuration bit and is one of a toggle magnetoresistive random access memory (MRAM), a spin orbit torque (SOT) MRAM, a spin transfer torque (STT) MRAM, or a voltage-controlled magnetic anisotropy (VCMA) MRAM.

It will be apparent to those skilled in the art that various modifications and variations can be made to the disclosed system without departing from the scope of the disclosure. Other embodiments of the system will be apparent to those skilled in the art from consideration of the specification and practice of the system disclosed herein. It is intended that the specification and examples be considered as exemplary only, with a true scope of the disclosure being indicated by the following claims and their equivalents.

### It follows a list of further embodiments of the invention:

Embodiment 1. A memory device comprising:
   a first configuration bit group including a plurality of bits, the plurality of bits including:
   a plurality of configuration bits;
   at least one redundant configuration bit;
   a plurality of configuration bit multiplexers each configured to receive (i) a first input from a first bit in the plurality of bits and/or a second input from a second bit in the plurality of bits and (ii) a third input from a decoder, each of the first, second, and third inputs indicating a respective logical state, wherein the logical state includes a first state or a second state; and
   wherein, based on the logical state of the third input received from the decoder, each configuration bit multiplexer is configured to output:
      the logical state of the first input from the first bit, or
      the logical state of the second input from the second bit.
Embodiment 2. The memory device with the features of embodiment 1, wherein, when one of the plurality of configuration bits is faulty, at least one of the plurality of configuration bit multiplexers receives the second input from the second bit in the plurality of bits.
Embodiment 3. The memory device with the features of embodiment 1, wherein, when one of the plurality of configuration bits is faulty, at least one of the plurality of configuration bit multiplexers receives the second input from the second bit in the plurality of bits, the second bit being the at least one redundant configuration bit.
Embodiment 4. The memory device with the features of embodiment 1, wherein the decoder is configured to selectively program the third input provided to each configuration bit multiplexer based on whether and/or where a faulty configuration bit exists.
Embodiment 5. The memory device with the features of embodiment 1, further comprising at least one redundant configuration bit multiplexer configured to receive an input from the at least one redundant configuration bit.
Embodiment 6. The memory device with the features of embodiment 1, further comprising a scan chain electrically connected to the plurality of bits and configured to test an output of each bit in the plurality of bits to determine any faulty bit.
Embodiment 7. The memory device with the features of embodiment 1, wherein the each bit in the plurality of bits is one of a toggle magnetoresistive random access memory (MRAM), a spin orbit torque (SOT) MRAM, a spin transfer torque (STT) MRAM, or a voltage-controlled magnetic anisotropy (VCMA) MRAM.
Embodiment 8. The memory device with the features of embodiment 1, further comprising:
   a second configuration bit group substantially identical to the first configuration bit group; and
   a configuration bit group multiplexer including:
      a select input,
      a first output to an input of the first configuration bit group, and
      a second output to an input of the second configuration bit group,
      wherein, based on a logical state of the select input to the configuration bit group multiplexer, the configuration bit group multiplexer is configured to selectively access one of the first configuration bit group or the second configuration bit group.
Embodiment 9. A memory device comprising:
   a plurality of configuration bits;
   an inversion bit, each of the plurality of configuration bits and the inversion bit having a respective logical state, wherein the logical state includes a first state or a second state; and
   an exclusive OR (XOR) tree circuit configured to receive an input from each of the plurality of configuration bits and the inversion bit and:
      if the inversion bit includes the first state, output the logical state of each corresponding configuration bit in the plurality of configuration bits, or
      if the inversion bit includes the second state, invert the logical state of each corresponding configuration bit in the plurality of configuration bits.
Embodiment 10. The memory device with the features of embodiment 9, wherein the inversion bit includes a plurality of inversion bits, and wherein the memory device further comprises:
   a triple modular redundancy (TMR) circuit configured to determine the logical state of the inversion bit by performing a majority voting based on the logical states of the plurality of inversion bits and output the determined logical state of the inversion bit to the XOR tree circuit.
Embodiment 11. The memory device with the features of embodiment 9, wherein the output of each configuration bit in the plurality of configuration bits is stored in a first portion of non-volatile memory having an address and is configured to be output by the XOR tree circuit,
   wherein the address is selectively stored in a second portion of the non-volatile memory when the inversion bit is fixed at the first state or the second state,
   and wherein the logical state of each configuration bit in the plurality of configuration bits is inverted when the address is stored in the second portion of non-volatile memory.
Embodiment 12. The memory device with the features of embodiment 9, wherein the each configuration bit in the plurality of configuration bits is one of a toggle magnetoresistive random access memory (MRAM), a spin orbit torque (SOT) MRAM, a spin transfer torque (STT) MRAM, or a voltage-controlled magnetic anisotropy (VCMA) MRAM.
Embodiment 13. The memory device with the features of embodiment 9, wherein the plurality of configuration bits includes at least four configuration bits.
Embodiment 14. A memory device comprising:
   a magnetic tunnel junction (MTJ) array electrically connected to a sense amplifier write driver circuit and to a write driver circuit, the MTJ array including:
   a first plurality of MTJ networks electrically coupled in parallel with one another, and
   a second plurality of MTJ networks electrically coupled in parallel with one another,
   wherein each MTJ network of the first plurality and the second plurality of MTJ networks includes a plurality of MTJs and is connected to the sense amplifier write driver circuit and the write driver circuit via respective multiplexers of a plurality of multiplexers,
   wherein the plurality of multiplexers are configured to select an MTJ network in the first plurality of networks and/or the second plurality of networks if one or more MTJs in one or more other MTJ networks in the first plurality of networks and/or the second plurality of networks are faulty.
Embodiment 15. The memory device with the features of embodiment 14, wherein the plurality of MTJs in each MTJ network are placed vertically adjacent each other and/or horizontally adjacent each other.
Embodiment 16. The memory device with the features of embodiment 14, wherein the memory device is a configuration bit.
Embodiment 17. The memory device with the features of embodiment 14, wherein each MTJ in the plurality of MTJs includes an MTJ stack including:
   a bottom electrode,
   a top electrode,
   a free layer between the bottom electrode and the top electrode,
   a fixed layer between the bottom electrode and the top electrode,
   a barrier layer between the free layer and the fixed layer.
Embodiment 18. The memory device with the features of embodiment 14, wherein the first plurality of MTJ networks and the second plurality of MTJ networks each include the same number of MTJ networks.
Embodiment 19. The memory device with the features of embodiment 14, wherein each MTJ network in the first plurality of MTJ networks and in the second network of MTJs includes a first multiplexer electrically connected to an input of the respective MTJ network and a second multiplexer electrically connected to a respective output of the respective MTJ network.
Embodiment 20. The memory device with the features of embodiment 14, wherein the memory device is a configuration bit and is one of a toggle magnetoresistive random access memory (MRAM), a spin orbit torque (SOT) MRAM, a spin transfer torque (STT) MRAM, or a voltage-controlled magnetic anisotropy (VCMA) MRAM

## Claims

1. A memory device comprising:
a first configuration bit group including a plurality of bits, the plurality of bits including:
a plurality of configuration bits;
at least one redundant configuration bit;
a plurality of configuration bit multiplexers each configured to receive (i) a first input from a first bit in the plurality of bits and/or a second input from a second bit in the plurality of bits and (ii) a third input from a decoder, each of the first, second, and third inputs indicating a respective logical state, wherein the logical state includes a first state or a second state; and
wherein, based on the logical state of the third input received from the decoder, each configuration bit multiplexer is configured to output:
the logical state of the first input from the first bit, or
the logical state of the second input from the second bit.

2. The memory device of claim 1, wherein, when one of the plurality of configuration bits is faulty, at least one of the plurality of configuration bit multiplexers receives the second input from the second bit in the plurality of bits.

3. The memory device of claim 1, wherein, when one of the plurality of configuration bits is faulty, at least one of the plurality of configuration bit multiplexers receives the second input from the second bit in the plurality of bits, the second bit being the at least one redundant configuration bit.

4. The memory device of claim 1, wherein the decoder is configured to selectively program the third input provided to each configuration bit multiplexer based on whether and/or where a faulty configuration bit exists.

5. The memory device of claim 1, further comprising at least one redundant configuration bit multiplexer configured to receive an input from the at least one redundant configuration bit.

6. The memory device of claim 1, further comprising a scan chain electrically connected to the plurality of bits and configured to test an output of each bit in the plurality of bits to determine any faulty bit and,
wherein the each bit in the plurality of bits is one of a toggle magnetoresistive random access memory (MRAM), a spin orbit torque (SOT) MRAM, a spin transfer torque (STT) MRAM, or a voltage-controlled magnetic anisotropy (VCMA) MRAM.

7. The memory device of claim 1, further comprising:
a second configuration bit group substantially identical to the first configuration bit group; and
a configuration bit group multiplexer including:
a select input,
a first output to an input of the first configuration bit group, and
a second output to an input of the second configuration bit group, wherein, based on a logical state of the select input to the configuration bit group multiplexer, the configuration bit group multiplexer is configured to selectively access one of the first configuration bit group or the second configuration bit group.

8. A memory device comprising:
a plurality of configuration bits;
an inversion bit, each of the plurality of configuration bits and the inversion bit having a respective logical state, wherein the logical state includes a first state or a second state; and
an exclusive OR (XOR) tree circuit configured to receive an input from each of the plurality of configuration bits and the inversion bit and:
if the inversion bit includes the first state, output the logical state of each corresponding configuration bit in the plurality of configuration bits, or
if the inversion bit includes the second state, invert the logical state of each corresponding configuration bit in the plurality of configuration bits.

9. The memory device of claim 8, wherein the inversion bit includes a plurality of inversion bits, and wherein the memory device further comprises:
a triple modular redundancy (TMR) circuit configured to determine the logical state of the inversion bit by performing a majority voting based on the logical states of the plurality of inversion bits and output the determined logical state of the inversion bit to the XOR tree circuit.

10. The memory device of claim 8, wherein the output of each configuration bit in the plurality of configuration bits is stored in a first portion of non-volatile memory having an address and is configured to be output by the XOR tree circuit,
wherein the address is selectively stored in a second portion of the non-volatile memory when the inversion bit is fixed at the first state or the second state,
and wherein the logical state of each configuration bit in the plurality of configuration bits is inverted when the address is stored in the second portion of non-volatile memory and,
wherein the each configuration bit in the plurality of configuration bits is one of a toggle magnetoresistive random access memory (MRAM), a spin orbit torque (SOT) MRAM, a spin transfer torque (STT) MRAM, or a voltage-controlled magnetic anisotropy (VCMA) MRAM and,
wherein the plurality of configuration bits includes at least four configuration bits.

11. A memory device comprising:
a magnetic tunnel junction (MTJ) array electrically connected to a sense amplifier write driver circuit and to a write driver circuit, the MTJ array including:
a first plurality of MTJ networks electrically coupled in parallel with one another, and
a second plurality of MTJ networks electrically coupled in parallel with one another,
wherein each MTJ network of the first plurality and the second plurality of MTJ networks includes a plurality of MTJs and is connected to the sense amplifier write driver circuit and
the write driver circuit via respective multiplexers of a plurality of multiplexers,
wherein the plurality of multiplexers are configured to select an MTJ network in the first plurality of networks and/or the second plurality of networks if one or more MTJs in one or more other MTJ networks in the first plurality of networks and/or the second plurality of networks are faulty.

12. The memory device of claim 11, wherein the plurality of MTJs in each MTJ network are placed vertically adjacent each other and/or horizontally adjacent each other and,
wherein the memory device is a configuration bit.

13. The memory device of claim 11, wherein each MTJ in the plurality of MTJs includes an MTJ stack including:
a bottom electrode,
a top electrode,
a free layer between the bottom electrode and the top electrode,
a fixed layer between the bottom electrode and the top electrode,
a barrier layer between the free layer and the fixed layer.

14. The memory device of claim 11, wherein the first plurality of MTJ networks and the second plurality of MTJ networks each include the same number of MTJ networks.

15. The memory device of claim 11, wherein each MTJ network in the first plurality of MTJ networks and in the second network of MTJs includes a first multiplexer electrically connected to an input of the respective MTJ network and a second multiplexer electrically connected to a respective output of the respective MTJ network and,
wherein the memory device is a configuration bit and is one of a toggle magnetoresistive random access memory (MRAM), a spin orbit torque (SOT) MRAM, a spin transfer torque (STT) MRAM, or a voltage-controlled magnetic anisotropy (VCMA) MRAM.
